Europäisches Patentamt

European Patent Office

Office européen des brevets

(11) Publication number: **0 353 731**
**A2**

# EUROPEAN PATENT APPLICATION

(21) Application number: 89114262.2

(51) Int. Cl.⁴: **G01R 29/10**

(22) Date of filing: **02.08.89**

(30) Priority: **02.08.88 JP 193061/88**

(43) Date of publication of application:
**07.02.90 Bulletin 90/06**

(84) Designated Contracting States:
**DE FR GB NL**

(71) Applicant: **AKZO KASHIMA LIMITED**
**1, Oaza Sunayama Hasaki-machi**
**Kashima-gun Ibaraki-ken(JP)**

(72) Inventor: **Kaibuchi, Sumio**
**10000-1577, Yatabedoai, Hasaki-machi**
**Kashima-gun, Ibaraki-ken(JP)**

(74) Representative: **Görtz, Dr. Fuchs, Dr.**
**Luderschmidt Patentanwälte**
**Abraham-Lincoln-Strasse 7 Postfach 46 60**
**D-6200 Wiesbaden(DE)**

(54) **Anechoic chamber.**

(57) Anechoic chamber comprising a floor wall, an anterior and posterior wall, a lefthand and righthand wall, and a ceiling wall invariably made of a metallic material and vested with an ability to intercept electromagnetic waves and incorporating therein a space for accommodation defined by the walls is disclosed. In the space for accommodation, a transmission source and a receiving antenna for receiving waves radiated from the transmission source are installed. The ceiling wall and the anterior, posterior, lefthand and righthand walls are formed as inclined by stated angles so that the waves reflected by the inclined walls are not allowed to reach directly the receiving antenna. The measurement of waves traveling from the transmission source directly to the receiving antenna, therefore, can be attained without being affected by reflected waves. Inside the inclined walls, electroconductive screens are disposed so as to serve the purpose of absorbing waves and preventing waves reflected thereby from directly reaching the receiving antenna. Electromagnetic wave absorbing members disclosed inside the inclined walls promote the absorption of waves.

F I G. 6

## ANECHOIC CHAMBER

## BACKGROUND OF THE INVENTION

### 1. Field of the Invention:

This invention relates to an anechoic chamber which is otherwise called, a semi-anechoic chamber, and particularly to an anechoic chamber which is small and capable of being installed within an existing building.

### 2. Description of the Prior Art:

Since various electronic devices represented by computers emit electromagnetic wave noises, it is necessary to measure waves generated by these devices. This measurement is basically performed outdoors to ensure the best possible detection of the condition of transmission of the generated waves. The outdoor measurement is susceptible of the influence of external waves and therefore incapable of accurate detection of waves. Moreover, the work of measurement is at the mercy of weather conditions. This measurement, therefore, cannot be relied on to warrant good repeatability. Whenever a newly developed antenna is to be tested for characteristic performance, it is necessary to measure incoming waves without being affected by external waves for the purpose of measuring the condition of reception of such waves by the antenna.

In order for the measurement to be performed without being affected by external waves, efforts are being continued for the development of an anechoic chamber. The version of the anechoic chamber which is intended to handle those waves from a wave generating source, entering a receiving antenna, and including waves reflected from the ground is called a semi-anechoic chamber. There are times when the term "anechoic chamber" is used exclusively in the narrow sense of the word in referring to the case where the receiving antenna is even prevented from entry of waves reflected on the ground solely for the sake of waves traveling through space. There are also times when the term "anechoic chamber" is used in the broad sense of the word in inclusively referring to the above case where the waves reflected on the ground are admitted.

The conventional anechoic chamber, for the purpose of intercepting external waves, has a space for accommodation enclosed therein with wall members of a metallic material and, for the purpose of preventing waves generated in the space for accommodation from being reflected on the wall members, has electromagnetic wave absorbers attached to the inner surfaces of the wall members. The electromagnetic wave absorbers which are usable in the conventional anechoic chamber include those called as pyramid type and those called as W type, for example. The electromagnetic wave absorber is formed of a carbon powder-containing foamed polyurethane resin in the shape of a quadrangular pyramid and are otherwise called as a resistor type electromagnetic wave absorber. The absorber of this type is adapted to effect the absorption of waves by converting the electric energy of waves by the heat-generating function of a resistor into thermal energy and, at the same time, preventing the surfaces of the absorber from reflecting waves. Since the performance of the absorber of this type depends most on the height of the absorber, the absorber has required its height to be set at more than about one third of the wavelength of waves to be absorbed. Depending on the frequency of the waves to be measured, therefore, the absorber is required to have a fairly large height. Further, the attenuated primary reflected waves return to the receiving antenna. For the prevention of this phenomenon, the conventional anechoic chamber is required to form the space for accommodation in amply large dimensions. This requirement at times renders materialization of this conventional anechoic chamber difficult.

The conventional electromagnetic wave absorber of another type makes use of a ferrite. The absorber of this type is produced by molding the ferrite in the shape of a tile and attaching the tile to the surface of a metallic plate. This absorber or wave-absorbing member is thought to constitute itself a broad-band resonator which is critically coupled with free space. Though this absorber is allowed to have a small thickness, it has upper and lower limits to the range of frequency in the good absorption of waves.

## SUMMARY OF THE INVENTION

An object of this invention is to provide an anechoic chamber which allows reduction in the volume of a space for accommodation and yet prevents primary reflected waves from reaching the receiving antenna, enjoys compactness, and permits accurate measurement of waves of a wide range frequency.

Another object of this invention is to provide an anechoic chamber which comprises a electromagnetic wave shielding ceiling wall and anterior, posterior, lefthand, and righthand walls invariably inclined and electroconductive screens disposed inside the inclined walls and adapted to form a space for seizing waves in cooperation with the walls.

A further object of this invention is to provide an anechoic chamber which comprises a multiplicity of wave-absorbing members arranged inside electromagnetic wave intercepting ceiling wall and anterior, posterior, lefthand and righthand walls and adapted to constitute themselves electromagnetic wave absorbing walls severally furnished with inclined inner surfaces.

In accordance with the present invention, there is provided an anechoic chamber, comprising a floor wall, an anterior and a posterior wall, a lefthand and a righthand wall, and a ceiling wall, and a first space for accommodation defined by the walls, and incorporating in the first space for accommodation a transmission source for radiation of waves and a receiving antenna for receiving the linearly polarization component of the waves radiated by the transmission source, which anechoic chamber is characterized by the fact that the floor wall, the anterior and posterior walls, the lefthand and righthand walls, and the ceiling wall are formed of a metallic material, at least one of the floor wall, the anterior, posterior, lefthand and righthand walls, and the ceiling wall is disposed as inclined by a stated angle relative to a reference line of the polarization of the receiving antenna, and an electroconductive screen incorporating therein an electroconductive material is disposed inside the inclined wall so as to form a second space for seizing waves with the inclined wall.

In the anechoic chamber of the present invention, of the plane waves traveling from a transmission source to a receiving antenna, those which are reflected by the inclined electromagnetic wave intercepting walls fail to reach the receiving antenna. Since the anechoic chamber is provided inside the walls with the electroconductive screens defining a space for seizing waves, it allows reduction in the volume of the space for accommodation and yet permits measurement of the condition of transmission of waves from the transmission source such as for example, a computer while preventing intrusive external waves from interfering with the measurement. Particularly, since the waves from the transmission source are not reflected by the wave-intercepting walls before they are passed through the electroconductive screens and part of them are repeatedly reflected and attenuated between the opposed surfaces of the electroconductive screens and the wave intercepting walls, not only the primary reflected waves but also the secondary and subsequent reflected waves fail to reach the receiving antenna.

## BRIEF DESCRIPTION OF THE DRAWINGS

Fig. 1 A is a perspective view illustrating the fundamental principle of this invention with respect to the condition of reflection of vertical polarization.

Fig. 1 B is a perspective view illustrating the fundamental principle of this invention with respect to the condition of reflection of horizontal polarization.

Fig. 1 C is a side view taken in the direction of the arrow 1c in Fig. 1B.

Fig. 1 D is a sectional view illustrating the fundamental principle of this invention with respect to the condition of reflection of waves inside the space for seizing waves formed between an electromagnetic wave intercepting wall and an electroconductive screen.

Fig. 2 is a perspective view illustrating a typical electroconductive screen.

Fig. 3 is a schematic perspective view illustrating a typical anechoic chamber as one embodiment of this invention.

Fig. 4 A is a sectional view taken in the direction of the arrow 4a-4a in Fig. 3.

Fig. 4 B is a sectional view taken in the direction of the arrow 4b-4b in Fig. 4A.

Fig. 4 C is a sectional view taken in the direction of the arrow 4c-4c in Fig 4A.

Fig. 5 is a perspective view illustrating a known electromagnetic wave absorber.

Fig. 6 is a schematic perspective view illustrating a typical anechoic chamber as another embodiment of this invention.

Fig. 7 A is a sectional view taken in the direction of the arrow in 7a-7a in Fig 6.

Fig. 7 B is a sectional view taken in the direction of the arrow 7b-7b in Fig. 7A.

Fig. 7 C is a sectional view taken in the direction of the arrow 7c-7c in Fig. 7A.

Fig. 8 A is a plan view schematically illustrating the structure of a typical anechoic chamber as yet another embodiment of this invention.

Fig. 8 B is a perspective view illustrating the structure of a typical ceiling wall as one embodiment of this invention.

Fig. 9 A is a schematic plan view illustrating a typical anechoic chamber as yet another embodiment of this invention.

Fig. 9 B is a sectional view taken in the direciton of arrow 9b-9b in Fig. 9A.

Fig. 9 C is a sectional view taken in the direction of arrow 9c-9c in Fig. 9A.

Figs. 10 to 13 are schematic plan views illustrating the conditions of disposition of electroconductive screens in typical anechoic chambers as still other embodiments of this invention.

## DESCRIPTION OF THE PREFERRED EMBODIMENTS

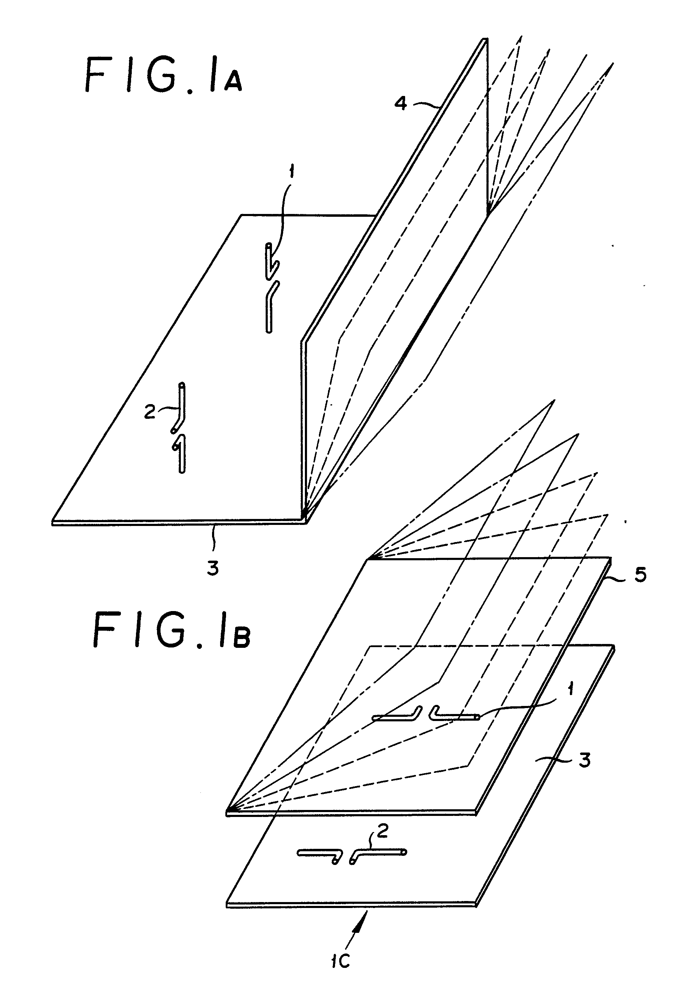

Fig. 1 A illustrates the fundamental principle of this invention, i.e. the condition in which linearly polarization antennas 1, 2 respectively for transmission and reception are disposed parallelly to each other and vertically relative to a floor wall 3 and waves are transmitted by the transmitting antenna 1 and received by the receiving antenna 2. In this case, a metallic side wall 4 is disposed parallelly to the antennas 1, 2 so that vertical polarization direct from the transmitting antenna 1 and vertical polarization of primary reflection reflected and attenuated by the floor wall 3 simultaneously reach the receiving antenna 2. The anechoic chamber is desired to be such that the space enclosed with metallic walls will be shielded the electromagnetic waves from outside and the reflected waves will be prevented from reaching the receiving antenna 2. It is conceivable that the amount of the reflected waves will be varied by the frequency of the waves, the distance between the two antennas 1, 2, and further by such factors as the distance to the floor walls 3.

An experiment carried out on the inclination of the side wall relative to the two antennas 1, 2 as indicated by imaginary lines in Fig. 1 A has ascertained that the inclination produces a change in the amount of waves received by the receiving antenna 2. As a result, it has been established that the desire to prevent the waves of primary reflection from reaching the receiving antenna 2 is attained by imparting an inclination to the side wall 4.

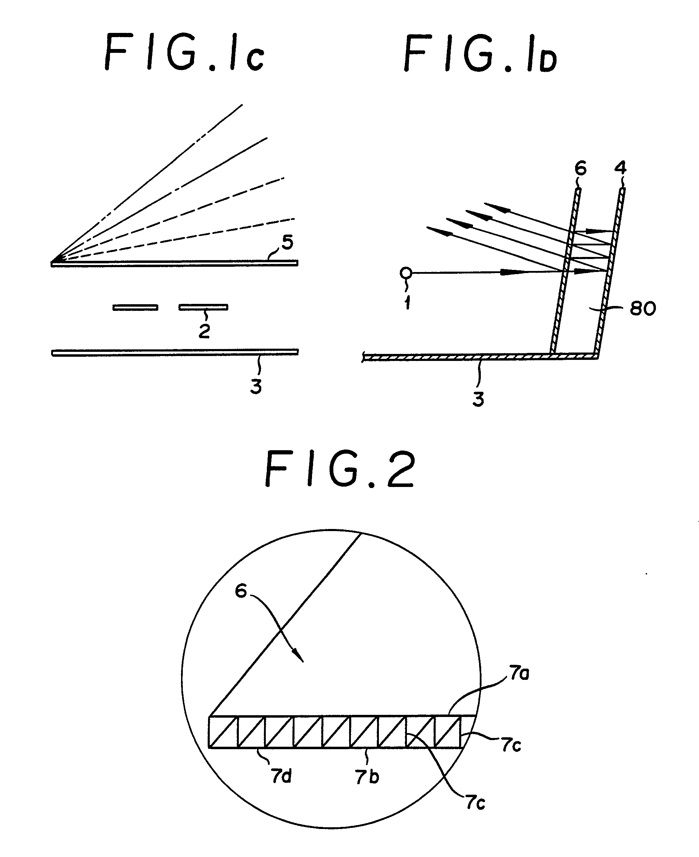

It has been found that even when a ceiling wall 5 is disposed above the floor wall 3 and the transmitting antenna and the receiving antenna 2 are disposed between the ceiling wall 5 and the floor wall 3 parallelly to each other and also parallelly to the floor wall 3 set in place in a horizontal state as illustrated in Fig. 1 B and Fig. 1 C so that the horizontal polarization from the transmitting antenna 1 are received by the receiving antenna 2, the desire to prevent the reflected waves from reaching the receiving antenna 2 is attained by imparting an inclination to the ceiling wall 5.

Fig. 1 D illustrates a configuration having a screen 6 disposed on the inside of the side wall 4 attached to the floor wall 3 as separated by a prescribed distance from the side wall. This screen 6 is made of a polypropylene resin matrix incorporating therein a wave absorbing material such as carbon powder and, therefore, is vested with electroconductivity. The structure of this electroconductive screen 6 is illustrated in detail in Fig. 2. It comprises two sheets 7a, 7b and a plurality of ribbonlike connecting sheets 7c disposed at regular intervals between the two sheets. These sheets 7a to 7c are formed of a polypropylene resin matrix incorporating therein carbon powder as an electroconductive material. They jointly define a multiplicity of equal spaces 7d of a tetrahedral cross section.

When the electroconductive screen 6 is set in place parallelly to the side wall 4 which is inclined upwardly as illustrated in Fig. 1 D, the waves from the transmitting antenna 1 are partly reflected by the electroconductive screen 6 and the remainder thereof are passed therethrough. The waves attenuated by this passage are allowed to reach the metallic side wall 4, further attenuated and reflected thereby, and again brought to the electroconductive screen 6. The waves are partly passed therethrough, with the remainder reflected and brought to the side wall again. Thus, a space 80 for seizing the passed waves is formed between the side wall 4 and the electroconductive screen 6.

By utilizing the phenomena of reflection and passage of waves described above, the present invention eliminates the reflected wave that are transmitted by the transmission source reflected by any walls and received by the receiving device and consequently maintains the anechoic chamber in a nearly ideal state.

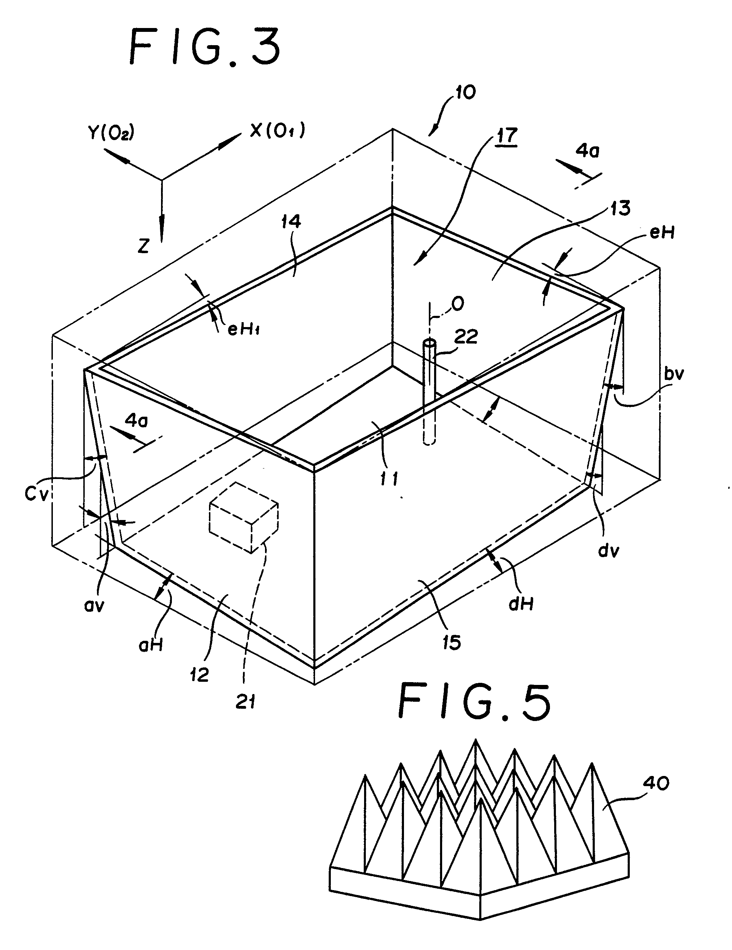

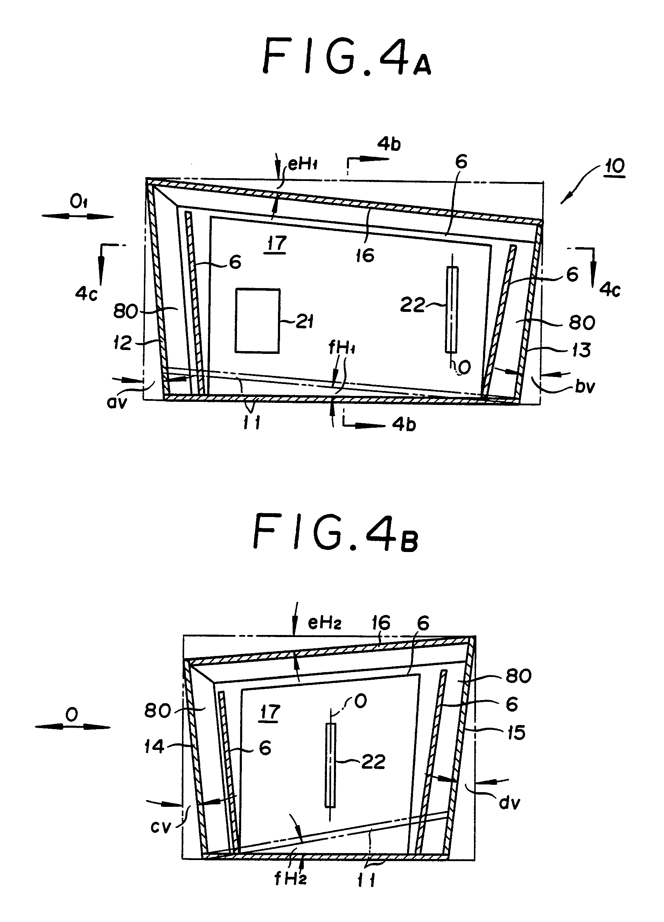

Fig. 3 and Fig. 4 A to Fig. 4 C are diagrams illustrating embodiments of this invention which is accomplished by the utilization of the nature of reflected waves mentioned above. These diagrams illustrate basic configurations of the anechoic chamber according with the present invention. The walls of the anechoic chambers illustrated in these diagrams are basically equal to those of the anechoic chamber disclosed in Japanese Patent Application SHO 62(1987)-270,257 already filed by the present applicant. An anechoic chamber 10 of this invention, as illustrated, comprises a floor wall 11, an anterior wall 12, a posterior wall 13, a lefthand wall 14, a righthand wall 15, and a ceiling wall 16 and contains therein a space 17 for accommodation as defined by the walls. In Fig. 2, however, the ceiling wall 16 is omitted from illustration. The walls 11 to 16 mentioned above are invariably formed of wave sheilding plates of such a metallic material as steel. Owing to the structure, the otherwise entry of external waves into the space 17 for accommodation is eliminated. On the floor wall 11, a transmission source 21 for radiating waves inside the space 17 for accommodation and a linearly polarization antenna 22 for receiving the linearly polarization component of the waves from the transmission source 21 are disposed. The linearly polarization antenna 22 used herein has the shape of a rod and has a reference line 0 of polarization. The receiving antenna 22 is set up in place so that the reference line 0 lies in a vertical line. This antenna 22 receives the vertical polarization from the transmission source 21.

The anterior wall 12 mentioned above, as illustrated in Fig. 3 and Fig. 4 A, is inclined by a stated angle, av, relative to the reference line 0 of the antenna 22. Similarly, the posterior wall 13 is inclined by a stated angle, bv, relative to the reference line 0. The lefthand wall 14, as illustrated in Fig. 4 B, is inclined by a stated angle, cv, relative to the reference line 0 of the antenna 22 and the righthand wall 15 is similarly inclined by a stated angle, dv. The walls 12 to 15 are inclined upwardly as illustrated.

Since the four walls 12 to 15 are inclined upwardly by respectively stated angles relative to the reference line 0 as mentioned above, of the vertical polarization from the transmission source 21, the primary reflection waves reflected by the walls 14, 15 are not allowed in their unaltered form to reach the receiving antenna 22.

There are times when the linearly polarization antenna 22 is set up in a horizontal state inside the space 17 as illustrated in Fig. 3 and Fig. 4 B to permit measurement of horizontal polarization from the transmission source 21. For the sake of this measurement, the ceiling wall 16 is inclined by a stated angle, eH2, relative to the reference line 0 which will assume a horizontal state in this case. Owing to the inclination of the ceiling wall 16 to be made in the manner mentioned above, even when the measurement of horizontal polarization is made by the use of the receiving antenna 22 having the reference line of polarization 0 in a horizontal state, the primary reflection waves from the ceiling wall 16 is no longer allowed to reach the receiving antenna 22 similarly to the case mentioned above. For the measurement of the horizontal polarization to be effected as mentioned above, since the distance between the walls 12, 13 is greater than the distance between the walls 14, 15, the transmission source 21 is required to be placed closer to the anterior wall 12 and the receiving antenna 22 closer to the posterior wall 13. For the sake of this measurement, the transmitting antenna 22 is installed in the space 17 accommodation in such a manner that the reference line 0 of polarization of the transmitting antenna 22 is directed in a horizontal line passing through the walls 14, 15.

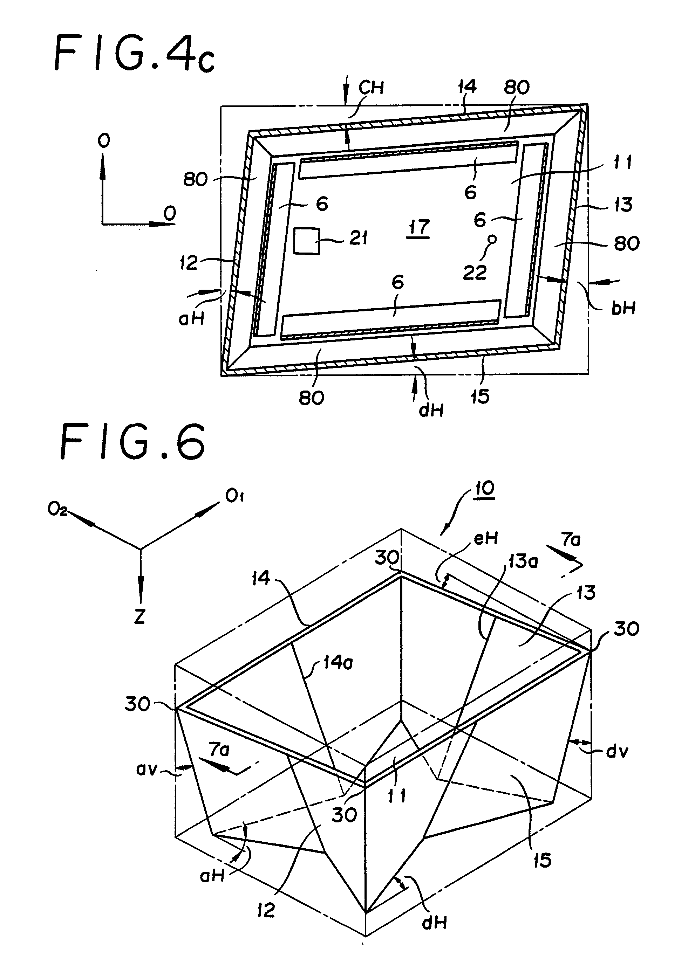

The horizontal line is directed perpendicularly to the vertical direction and may be divided into the first horizontal line (X-axis direction) passing through the opposed walls 12, 13 and the second horizontal line (Y-axis direction) passing through the opposed walls 14, 15. In Fig. 3 and Fig. 4, the first horizontal line is denoted by a numeral of 01 and the second horizontal line by a numeral of 02. Thus, the lefthand wall 14 and the righthand wall 15 are inclined respectively by stated angles, cH and dH, as illustrated in Fig. 4 C, relative to the first horizontal line 01 and the anterior wall 12 and the posterior wall 13 are inclined respectively by stated angles, aH and bH, relative to the second horizontal line 02. By the same token, the ceiling wall 16 is inclined by a stated angle, eH1, as illustrated in Fig. 4 A, relative to the first horizontal line 01 and by a stated angle, eH2, as illustrated in Fig. 4 B, relative to the second horizontal line 02. When only the horizontal polarization component of the waves from the transmission source 21 is measured, the reach of the primary reflection waves from the ceiling wall 16 on the receiving antenna 22 can be eliminated by causing the ceiling wall 16 to be inclined by the angle, eH2, relative to the second horizontal line 02, namely without requiring any inclination of the other walls 11 to 15. In this case, however, the receiving antenna 22 is set in place in advance so that the reference line of polarization will run parallelly to the second horizontal line 02. In this case, since the primary reflection waves from the floor wall 11 reach the receiving antenna 22, the chamber serves as a semi-anechoic chamber. For this chamber to serve as an anechoic chamber in the narrow sense of the word, the floor wall 11 is also required to be inclined by an angle, fH2, illustrated by an imaginary line in Fig. 2 B.

Similarly, in the selective measurement of the vertical polarization component of waves, the reach of the primary reflection waves to the receiving antenna can be prevented by causing only the walls 14, 15 to be inclined by the stated angles mentioned above. Normally, the anechoic chamber 10 is used for the measurement of both vertical polarization component and horizontal polarization component of waves. To prevent the reflected waves from returning to the receiving antenna 22, therefore, it is desirable that the four walls should be inclined in the two directions as mentioned above and, at the same time, the ceiling wall 16 should be inclined relative to the second horizontal line 02, and preferably the ceiling wall 16 should be inclined in the two directions relative to the first and second horizontal lines 01 and 02. Preferably for the chamber to function as an anechoic chamber in the narrow sense of the word mentioned above, it is desirable that the floor wall 11 should be also inclined relative to either or both of the first and second horizontal lines 01, 02.

In Fig. 3 and Fig. 4 A to Fig. 4 D, only the basic structures of the walls 11 to 16 are illustrated. To the walls 12 to 16 other than the bottom wall 11, resistor type electromagnetic wave absorber of a known structure may be attached as illustrated in Fig. 5. Their attachment promotes the attenuation of the reflected waves. Optionally, electromagnetic wave absorber of the type producted by molding a ferite in the shape of a tile may be interposed between the walls 12 to 16 and the resistor type electromagnetic wave absorber. These two types of electromagnetic wave absorbers may be attached to the inner surface of the bottom plate 11. The front wall 12 is provided with a door for admitting a worker in the space 17 for accommodation. A machine room and a measuring room may be adjoined to the anechoic chamber 10 illustrated .

The walls 11 to 16 can be formed of metallic plates as mentioned above. Depending on the wavelength of the waves radiated by the transmission source 21, they may be formed of metallic nets instead of metallic plates. In this case, for the purpose of preventing external waves from entering the space 17 for accommodation, the walls 12 to 16 are desired to be covered externally with plates of such a metallic material as iron to shield the empty space 17.

In addition to having the walls 11 to 16 inclined as mentioned above, the present invention contemplates having electroconductive screens 6 of a structure of Fig. 1 D disposed inside all of the walls 12 to 15 excepting the bottom wall 11 and the ceiling wall 16 as separated by a stated distance from the walls as illustrated in Fig. 4 A to Fig. 4 C. This distance is greater than the height of the electromagnetic wave absorber 40 to be attached to the inner surfaces of the walls. The electroconductive screens 6 which are illustrated are parallel to the corresponding walls 12 to 15 and are invariably inclined outwardly in the upward direction. Between the electroconductive screens 6 and the corresponding walls 12 to 15, spaces 80 for seizing waves are formed.

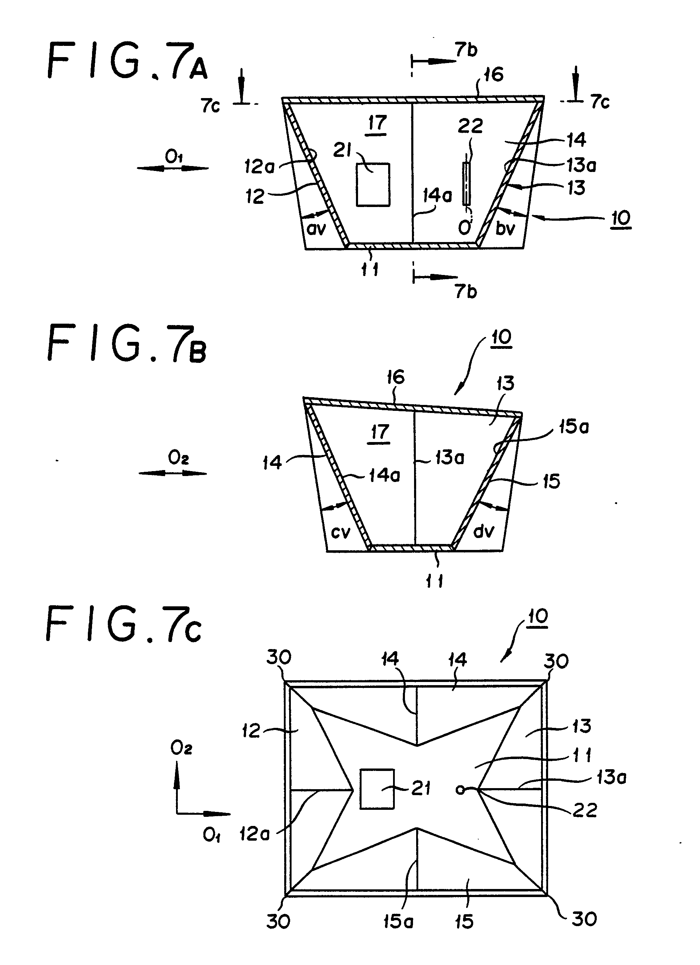

Fig. 6 and Fig. 7 A to Fig. 7 C illustrate a typical anechoic chamber 10 as another embodiment of the present invention. In these illustrations, the electroconductive screens are omitted. In these illustration, the components which have equivalents in the embodiment mentioned above are denoted by the same reference numerals. In this case, the floor wall 11 is not inclined in any direction but is held in the horizontal direction. The anterior and posterior walls 12, 13 and the lefthand and righthand walls 14, 15 are inclined outwardly in the upward direction. For the lefthand and righthand walls 14, 15 to be inclined relative to the first horizontal line 01, these walls 14, 15 are formed in such a manner that the distance horizontally separating them is smallest between the central parts 14a, 15a thereof and increases in the direction of the end 30. In other words, the walls 14, 15 are inclined from the central parts 14a, 15a thereof in the opposite direction relative to the first horizontal line 01.

Similarly, for the walls 12, 13 to be inclined relative to the second horizontal line 02, these walls 12, 13 are formed in such a manner that the distance horizontally separating them is smallest between the central parts 12a, 13a thereof and increases in the direction of the end 30. In other words, the walls 12, 13 are inclined from the central parts 12a, 13a thereof in the opposite directions relative to the second horizontal line 02.

By having the walls 12 to 15 bent along the respective central parts and consequently inclined relative to the corresponding horizontal lines, the volume of the space 17 for accommodation inside the anechoic chamber can be increased considerably as compared with the space of the anechoic chamber of the embodiment mentioned above. Therefore, if the walls had slanted larger, wider space 17 would be obtained. In consideration of the fact that the receiving antenna 22, for the reception of the horizontal polarization component of the radiated waves, is set in place in such a manner that the receiving reference line 0 of polarization thereof may lie parallelly to the second horizontal line 02, the ceiling wall 16 illustrated in Fig. 3 and Fig. 4 is inclined only relative to this second horizontal line 02. Similarly to the ceiling wall in the first embodiment, the ceiling wall 16 may be inclined in two directions.

The walls 12 to 15 in the embodiment illustrated in Fig. 6 and Fig. 7 A to Fig. 7 C are formed in a bent manner as illustrated. When the walls are inclined in this manner, unlike those inclined in the manner of the first embodiment mentioned above, the walls 12 to 15 do not have flat surfaces but bent surfaces. For the production of walls 12 to 15 having such bent surfaces as mentioned above, these walls are desired to be formed of such a material as a metallic net mentioned above. In this case, the walls 12 to 15 are each to be produced by first shaping a frame in the pattern roughly conforming to the contour of wall and then applying a metallic net to the inner surface of the shaped frame. Further in this case, the walls 12 to 15 are covered externally with metallic plates capable of preventing external waves from penetrating the walls.

Also in the case of this embodiment, similarly to the first embodiment, electromagnetic wave absorbers of a varying type may be attached to the inner surfaces of the walls 11 to 16. Fig. 8 A is a diagram illustrating a configuration having electromagnetic wave absorber attached to the inner surfaces of the walls of the anechoic chamber illustrated in Fig. 7 C. In this case, the walls 12 to 16 are inclined in the same manner as those in the embodiment illustrated in Fig. 3 and Fig. 4 and, at the same time, electromagnetic wave absorbers 40 are attached to the inner surfaces of the wall 12 to 15 as described above. In this case, the primary reflected waves are prevented from returning to the receiving antenna 22 and the reflected waves are attenuated by the wave-absorbing members 40.

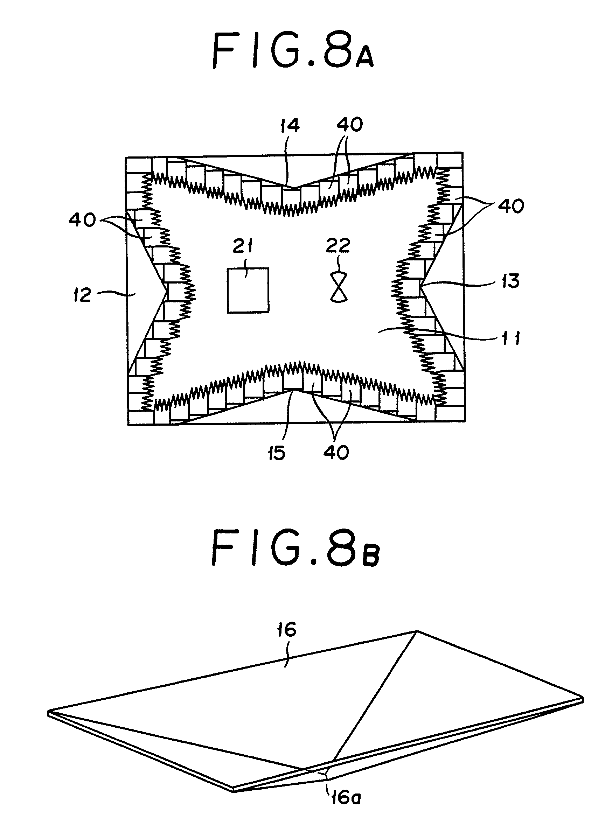

Fig. 8 B illustrates a configuration having the ceiling wall 16 formed in the general shape of a tetrahedral pyramid so that the distance vertically separating the ceiling wall 16 and the floor wall 11 is smallest in the central part 16a of the ceiling wall and increases in the direction of the four corners of the pyramid. A electromagnetic wave absorber 40 is attached to the inner surface of the ceiling wall 16.

In any of the embodiments described above, the walls may be selected in either of the two directions in which two opposed pairs of walls are arranged.

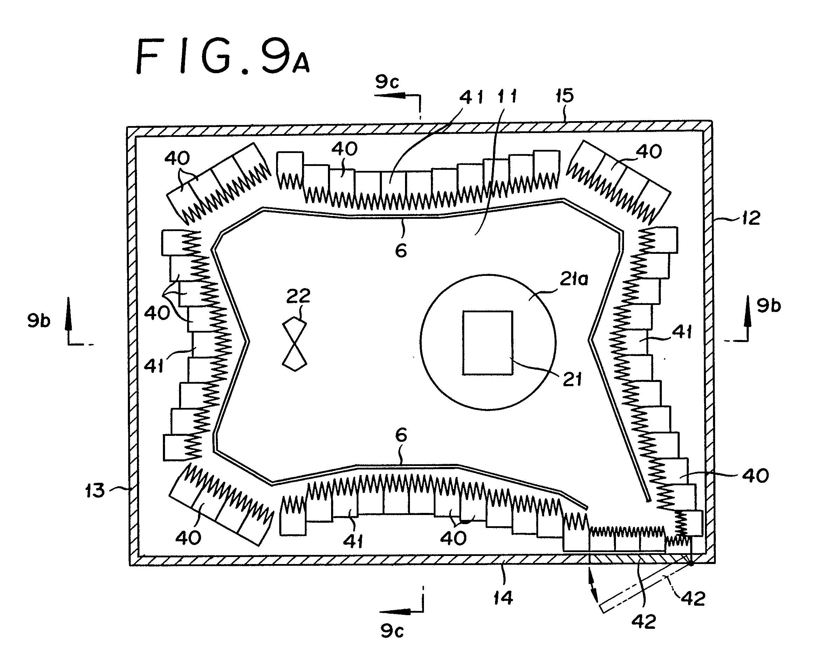

Fig. 9 A to Fig. 9 C are diagrams illustrating a typical anechoic chamber as yet another embodiment of the present invention. In the diagrams, the component members which have equivalents in the embodiments mentioned above are denoted by the same referential numerals.

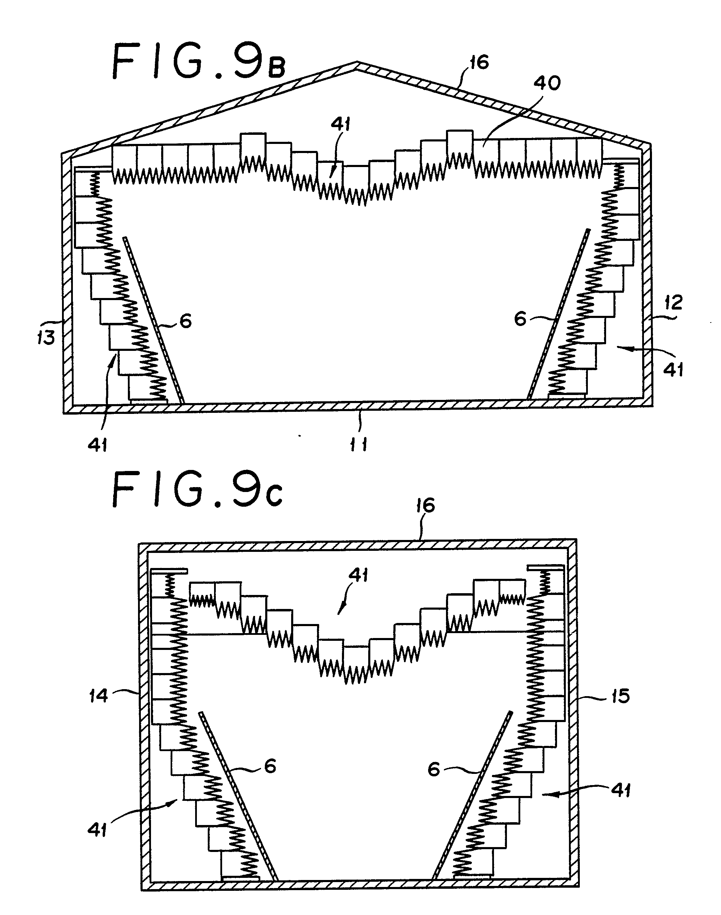

In this anechoic chamber, the floor wall 11 is disposed horizontally and the walls 12 to 15 are invariably disposed vertically and the ceiling wall 16 is inclined upwardly in the direction of the central part 16b. In this case, while the walls 12 to 15 are not inclined, electromagnetic wave absorbing walls which are formed of a multiplicity of electromagnetic wave absorbers 40 are inclined within the horizontal plane as illustrated in Fig. 9 A and the individual electromagnetic wave absorbers are inclined outwardly in the upward direction as illustrated in Fig. 9 B and Fig. 9 C. In the present embodiment, the electroconductive screens 6 are disposed inside the inner surfaces of the electromagnetic wave absorbing walls as separated by a stated distance therefrom. The electroconductive screens 6 are disposed parallel to the electromagnetic wave absorbing walls 41 and are inclined outwardly in the upward direction as illustrated in Fig. 9 B and Fig. 9 C. No electroconductive screen 6 is disposed in the portion corresponding to the entrance 42 formed in the lefthand wall 14 as illustrated in Fig. 9 A. In Fig. 9 A, the reference numeral 21a denotes a turntable which rotatably support the transmission source 21 in place.

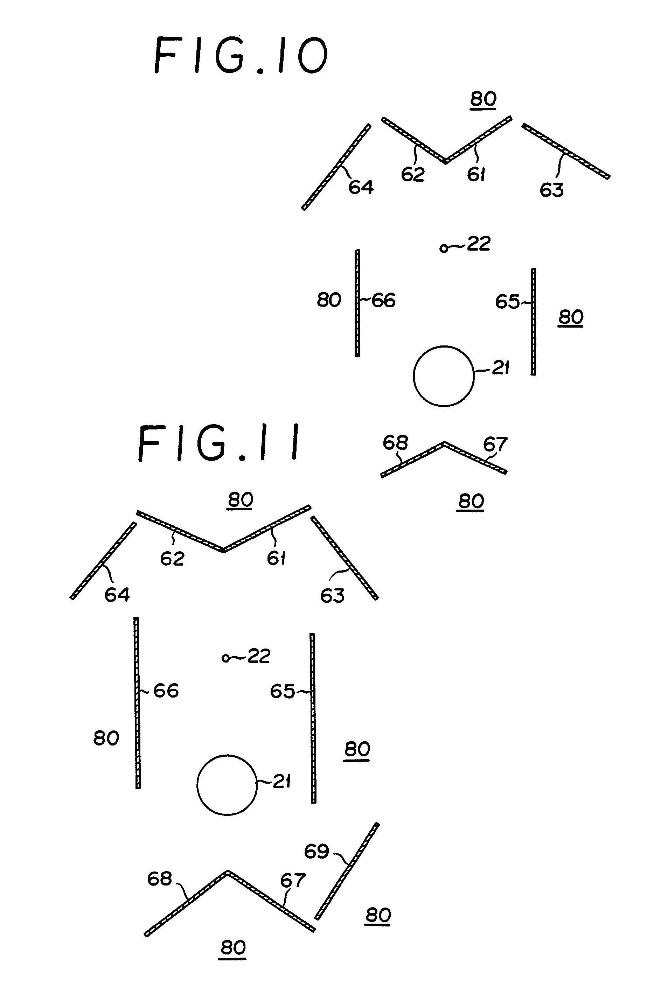

Fig. 10 is a diagram illustrating the disposition of electroconductive screens in a typical anechoic chamber as still another embodiment of this invention. In the diagram, all of the walls described above are omitted. The electroconductive screens are disposed at stated angles without reference to the angles of the walls.

As illustrated, on the receiving antenna 22 side, two electroconductive screens 61, 62 are disposed as inclined in mutually opposite directions relative to the horizontal line, with the part of the center line interconnecting the receiving antenna 22 and the transmitting antenna 21 as the boundary. On both sides of these screens 61, 62, electroconductive screens 63, 64 are disposed as separated respectively by stated distances therefrom and inclined relative to the horizontal line by an angle different from that of the screens 61, 62 mentioned above. These screens 61 to 64 are adjoined to the posterior wall 13 mentioned above across an space 80 for seizing waves. On both sides of the antennas 21, 22, electroconductive screens 65, 66 are disposed in a stated positional relation with the distance separating the antennas. Further, on the transmitting antenna 21 side, two electroconductive screens 67, 68 are disposed as inclined in the mutually opposite directions relative to the horizontal line. The screens 61 to 68, similarly to those in the embodiment mentioned above, are invariably inclined outwardly in the upward direction. For example, the screen 61 is inclined outwardly by an angle of $14°$, the screen 61 by an angle of $13°$, the screen 63 and the screen 64 each by an angle of $18°$, and screen 65 by an angle of $34°$, the screen 66 by an angle of $31°$, and the screen 67 and the screen 68 each by an angle of $28°$.

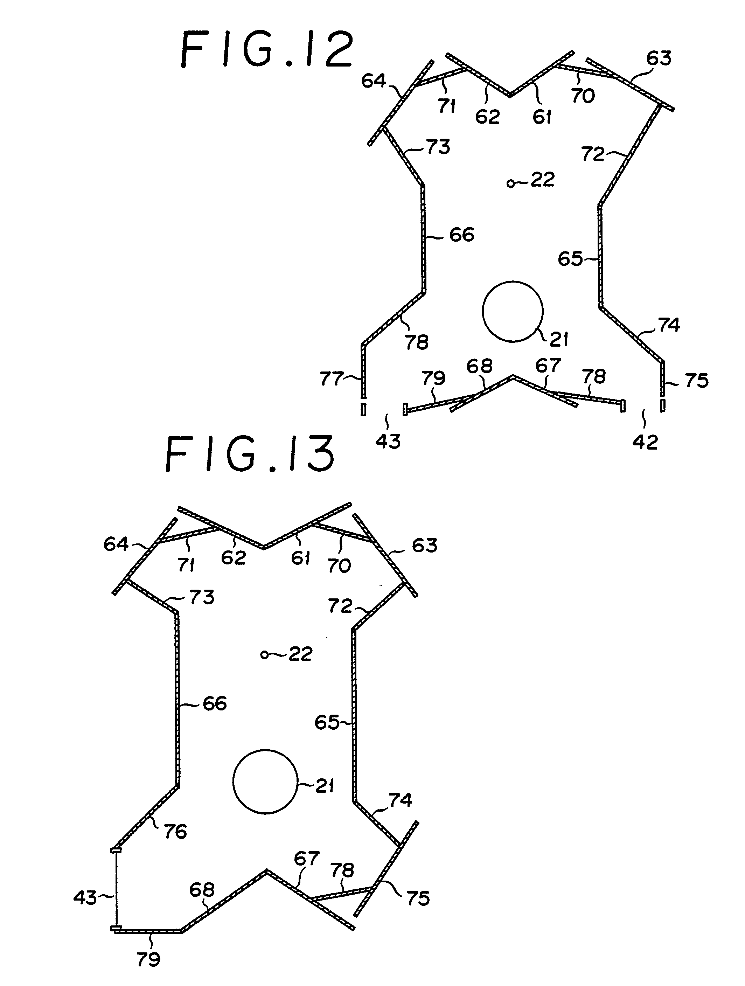

Fig. 11 illustrates a typical disposition of electroconductive screens as a further embodiment of this invention. In this embodiment, another electroconductive screen 69 is disposed in a corner portion in addition to the screens 61 to 68 illustrated in Fig. 10. The position of this electroconductive screen 69 corresponds to the corner portion where the righthand wall 15 and the anterior wall 12 are joined to each other.

Fig. 12 illustrates a typical disposition of electroconductive screens as another embodiment of this invention. In this case, a screen 70 overlapping the screens 61 and 63, a screen 71 overlapping the screens 62 and 64, a screen 72 intervening between the screens 63 and 65, and a screen 73 intervening between the screens 64 and 66 are provided in addition to those screens illustrated in Fig. 10. Further, two screens 74 and 75 are connected to the screen 65 and two other screens 76 and 77 are connected to the screen 66. The entrance for a worker is formed between the screen 75 mentioned above and a screen 78 partially overlapping the screen 67. Similarly, another entrance 43 is formed between the screen 77 mentioned above and a screen partially overlapping the screen 68.

Another embodiment of this invention illustrated in Fig. 13 has substantially the same basic configuration as that of Fig. 12, excepting the screen 79 and the screen 75 are disposed differently. Thus, the electroconductive screens can be set at arbitrarily selected positions.

In accordance with this invention, of the waves radiated from the transmission source, those of primary reflection by walls are prevented from being returned to the receiving antenna as mentioned above. Even with a small anechoic chamber possessing a narrow space for accommodation, therefore, the measurement of waves generated from an electronic device such as a computer can be carried out with high accuracy.

## Claims

1. An anechoic chamber, comprising a floor wall, an anterior and a posterior wall, a lefthand and a righthand wall, and ceiling wall, and a first space for accommodation defined by said walls, and incorporating in said first space for accommodation a transmission source for radiation of waves and a receiving antenna for receiving the linearly polarization component of said waves radiated by said transmission source, which anechoic chamber is characterized by the fact that said floor wall, said anterior and posterior walls, said lefthand and righthand walls, and said ceiling wall are formed of a metallic material, at least one of said floor wall, said anterior and posterior walls, said lefthand and righthand walls, and said ceiling wall is disposed as inclined by a stated angle relative to a reference line of said polarization of said receiving antenna, and an electroconductive screen incorporating therein an electroconductive material is disposed inside said inclined wall so as to form a second space for seizing waves with said inclined wall.

2. An anechoic chamber according to claim 1, wherein said anterior and posterior walls and said lefthand and righthand walls are inclined outwardly in the upward direction and, at the same time, inclined relative to the horizontal line and, inside the four walls, as many electroconductive screens are disposed parallelly thereto.

3. An anechoic chamber according to claim 2, wherein electromagnetic wave absorbers are interposed between said four walls and said electroconductive screens.

4. An anechoic chamber according to claim 1, wherein said floor wall, said anterior and posterior walls, said lefthand and righthand walls, and said ceiling wall are invariably inclined.

5. An anechoic chamber, comprising a floor wall, an anterior and a posterior wall, and a lefthand and a righthand wall, and ceiling wall, and a first space for accommodation defined by said walls, and incorporating in said first space for accommodation a transmission source for radiation of waves and a receiving antenna for receiving the linearly polarization component of said waves radiated by said transmission source, which anechoic chamber is characterized by the fact that said floor wall, said anterior and posterior walls, said lefthand and righthand walls, and said ceiling wall are formed of a metallic material, said anterior, posterior, lefthand and righthand walls are inclined outwardly in the upward direction and said four walls are severally inclined outwardly from the central part in the horizontal direction toward the opposite terminal parts, and inside said inclined anterior, posterior, lefthand and righthand walls, electroconductive screens incorporating therein an electroconductive material are disposed so as to form a second spaces for seizing waves with said inclined walls.

6. An anechoic chamber according to claim 5, wherein said ceiling wall is inclined.

7. An anechoic chamber, comprising a floor wall, an anterior and a posterior wall, a lefthand and a righthand wall, and a ceiling wall, and a first space for accommodation defined by said walls, and incorporating in said first space for accommodation a transmission source for radiation of waves and said a receiving antenna for receiving the linearly polarization component of said waves radiated by said transmission source, which anechoic chamber is characterized by the fact that said floor wall, said anterior and posterior walls, said lefthand and righthand walls, and said ceiling wall are formed of a metallic material, said anterior, posterior, lefthand, and righthand walls are erected in the perpendicular direction and sequentially joined so as to form rectangular corners in the horizontal direction, a multiplicity of electromagnetic wave absorbers disposed inside said anterior, posterior, lefthand, and righthand walls jointly form electromagnetic wave absorbing walls having the inner surfaces thereof inclined upwardly and a multiplicity of electromagnetic wave absorbers jointly form a electromagnetic wave absorbing wall inside said ceiling wall, and electroconductive screens incorporating therein an electroconductive material are disposed inside said anterior, posterior, lefthand, and righthand electromagnetic wave absorbing walls so as to form a second spaces for seizing waves with said walls.

8. An anechoic chamber according to claim 7, wherein said anterior, posterior, lefthand, and righthand electromagnetic wave absorbing walls are inclined also in the horizontal direction from the central part thereof to the end of said absorbing walls and said electromagnetic wave absorbing wall formed inside said ceiling wall is also inclined from the central part thereof to the peripheral part thereof.

9. An anechoic chamber, comprising a floor wall, an anterior and a posterior wall, a lefthand and a righthand wall, and ceiling wall and a space for accommodation defined by said walls, and incorporating in said empty space for accommodation a transmission source for radiation of waves and a receiving antenna for receiving the linearly polarization component of said waves radiated by said transmission source,

which anechoic chamber is characterized by the fact that said floor wall, said anterior, posterior, lefthand and righthand walls, and said ceiling wall are formed of a metallic material,

and at least one of said floor wall and said anterior, posterior, lefthand and righthand walls is inclined by a stated angle relative to a reference line of said polorization of said receiving antenna.

10. An anechoic chamber according to claim 9, wherein said anterior, posterior, lefthand and righthand walls are inclined by stated angles upwardly relative to the vertical line,

said anterior and posterior walls which are opposed to each other are inclined by stated angles relative to the horizontal line passing through said lefthand and righthand walls and forming right angles with said vertical line,

said lefthand and righthand walls which are opposed to each other are inclined by stated angles relative to the horizontal line passing through said anterior and posterior walls and forming right angles with said vertical line,

and said ceiling wall and said bottom wall are inclined by stated angles relative to said horizontal line.

11. An anechoic chamber according to claim 9, wherein said anterior and posterior walls are inclined so that the horizontal distance separating them is smallest between the central parts thereof and increases in the direction of the terminal parts thereof and said lefthand and righthand walls are inclined so that the horizontal distance separating them is smallest between the central parts thereof and increases in the direction of the terminal parts thereof.

FIG.1A

FIG.1B

FIG.1c

FIG.1D

FIG.2

# FIG.3

# FIG.5

# FIG.4A

# FIG.4B

# FIG.4c

# FIG.6

FIG.7A

FIG.7B

FIG.7C

# F I G.8A

# F I G.8B

# FIG.9A

EP 0 353 731 A2

# FIG.9B

# FIG.9c

# F I G . IO

# F I G . I I

FIG.12

FIG.13